Europäisches Patentamt

European Patent Office

Office européen des brevets

(11) Publication number:

0 326 746
A2

## (12) EUROPEAN PATENT APPLICATION

(21) Application number: 88310496.0

(22) Date of filing: 08.11.88

(51) Int. Cl.⁴: H03J 7/18

(30) Priority: 05.02.88 JP 25404/88

(43) Date of publication of application:
09.08.89 Bulletin 89/32

(84) Designated Contracting States:
DE FR GB

(71) Applicant: PIONEER ELECTRONIC
CORPORATION
No. 4-1, Meguro 1-chome
Meguro-ku Tokyo 153(JP)

(72) Inventor: Kasa, Kohichi Pioneer Electronic
Corporation
Kawagoe Works No. 25-1, Aza Nishi-machi
Oaza Yamada Kawagoe-shi Saitama(JP)
Inventor: Ichikawa, Toshihito Pioneer
Electronic Corporation
Kawagoe Works No. 25-1, Aza Nishi-machi
Oaza Yamada Kawagoe-shi Saitama(JP)
Inventor: Nishida, Junichi Pioneer Electronic
Corporation
Kawagoe Works No. 25-1, Aza Nishi-machi
Oaza Yamada Kawagoe-shi Saitama(JP)

(74) Representative: Brunner, Michael John et al
GILL JENNINGS & EVERY 53-64 Chancery
Lane
London WC2A 1HN(GB)

(54) Radio data system receiver.

(57) An RDS receiver has a controller means (14) for determining when no RDS broadcasting wave can be received by the receiver at the present received frequency thereof for one of plural broadcasting stations constituting a network and also that a change of the present received frequency to the frequency of another one of the broadcasting stations, which is given by the AF data on the network of stations, has not been completed. The means (14) provides an indication of this to the listener of the receiver if such determination is made.

EP 0 326 746 A2

FIG. 1

# RADIO DATA SYSTEM RECEIVER

The present invention relates to a receiver for a radio data system broadcast (hereinafter referred to as an "RDS receiver").

In a radio data system broadcast, broadcasting-related information such as information on the contents of programs is transmitted, through multiplex modulated broadcasting of the program from a broadcasting station and demodulation on reception, to obtain data to enable a radio listener to choose a desired one of the programs on the basis of the broadcast data. In such systems, a wave of 57 kHz frequency, which is the third harmonic of a stereo pilot signal of 19 kHz is used as a subcarrier wave outside the frequency band of a frequency modulation wave and subjected to amplitude modulation by a data signal obtained by filtering and biphase coding, and indicates broadcasting-related information such as the information on the contents of the programs, so that a radio data signal is obtained through the amplitude modulation. The subcarrier wave is combined with a main carrier wave, by frequency modulation, for broadcasting.

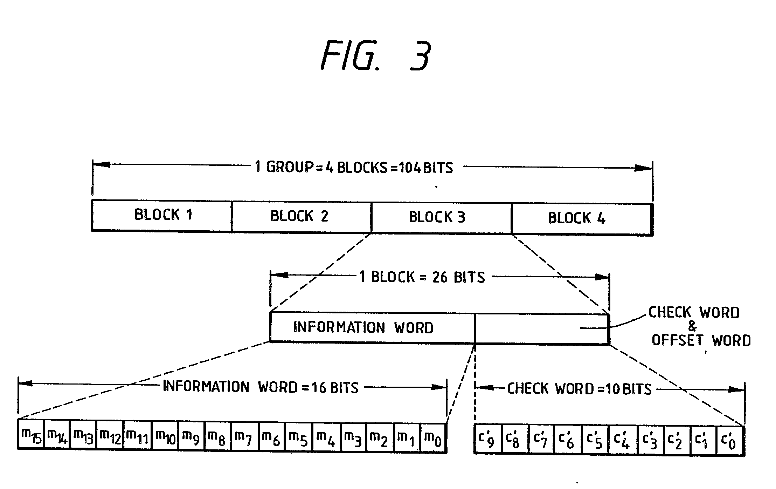

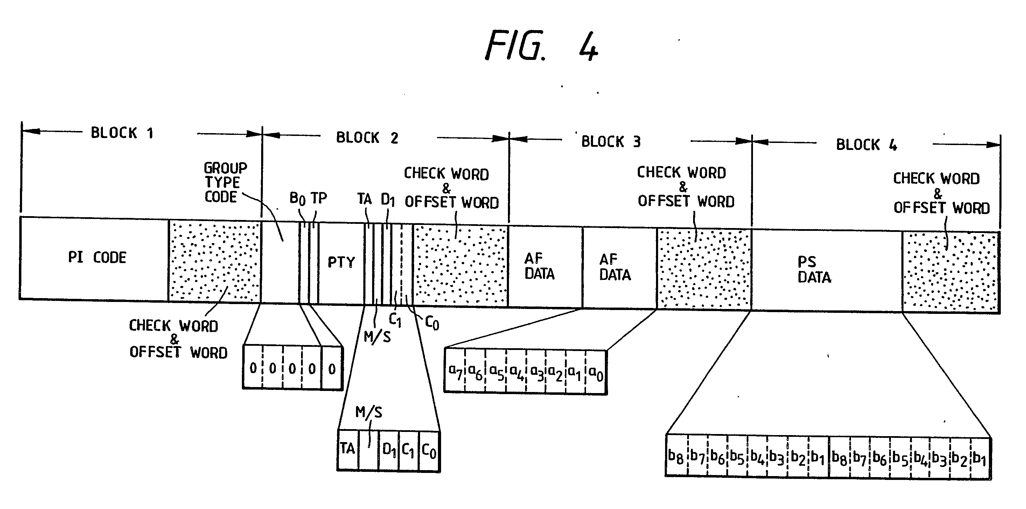

The radio data signal is subjected to repeated multiplex transmission as every 104 bits of the signal are handled as a group (as will be understood from FIG. 3 showing the base band coding structure of the radio data signal). The group comprises four blocks each consisting of 26 bits. Each of the blocks consists of a 16-bit information word and a 10-bit check word. As shown in FIG. 4, program identity data (PI data) is disposed in the first block 1, road traffic program recognition data (TP data) and road traffic announcement recognition data (TA data) is disposed in the second block 2, data (AF data) on the frequencies of broadcasting stations constituting the network of stations broadcasting the same program is disposed in the third block 3, and data (PS data) on a program service name such as the names of the broadcasting stations and that of the network is disposed in the fourth block 4. The groups are classified into sixteen types 0, 1, 2, 3, 4, 5, 6, 7, 8, 9, 10, 11, 12, 13, 14 and 15 by four bits, depending on the contents of the groups. Two versions A and B are defined for the types. The codes of the type and version of each group are disposed in the second block 2. The AF data are transmitted only in the group of the type 0 of the version A.

With an RDS receiver mounted in a vehicle, the reception of a broadcasting wave is likely to deteriorate along with the movement of the vehicle. However, if plural RDS broadcasting signals from a plurality of broadcasting stations constituting a network and broadcasting the same program can be received by the RDS receiver to obtain AF data, the received frequency of the receiver can be changed from the frequency of one of the broadcasting stations to that of another through the utilization of the AF data to receive the RDS broadcast well. However, since there is a limit to the number of the broadcasting stations consituting the network, it may be that none of the broadcasts can be received well by the receiver even if the received frequency is changed through the frequencies of all the broadcasting stations. In that case, road traffic information fails to be heard if the receiver is in a state of waiting for road traffic announcement interruption based on TA data, for example. This is a problem which the present invention sets out to overcome.

Accordingly, it is an object of the present invention to provide an RDS receiver, in which, when it has become impossible for the receiver to receive an RDS broadcasting wave at any of the frequencies of broadcasting stations constituting the selected network, the listener can be notified of the impossibility in a simple manner.

The invention is characterized in that when no RDS broadcasting wave can be received by the receiver at the present received frequency thereof for one of the broadcasting stations and the change of the present received frequency to the frequency for another one of the broadcasting stations, which is given by the TA data on all the broadcasting stations, has not been completed, the listener is notified of this situation.

An embodiment of the present invention is hereafter described in detail with reference to the drawings attached hereto, in which:

FIG. 1 shows a block diagram of a RDS receiver;

FIG. 2 shows a flow chart of the steps of the control method, which are taken by the processor of the controller of the RDS receiver;

FIG. 3 shows the base band coding structure of a radio data signal; and,

FIG. 4 shows the format of a group of a type 0 of a version A.

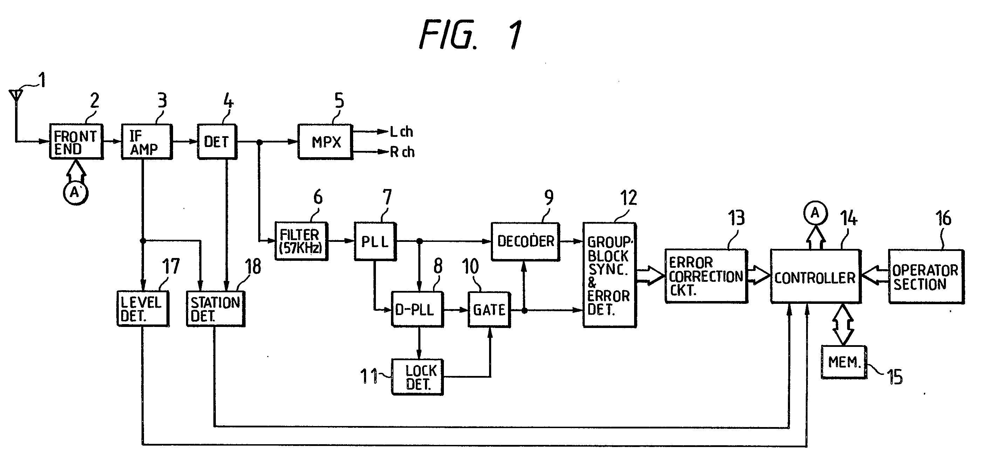

FIG. 1 shows the construction of an RDS receiver to which a control method is applied. A desired broadcasting station is chosen by a front end 2 from frequency modulation (FM) multiplex broadcast waves received by an antenna 1. After conversion to an intermediate frequency (IF), a signal is supplied from the front end 2 to a frequency modulation detector 4 thorugh an IF amplifier 3.

The front end 2 has a phase locked loop (PLL) synthesizer system employing a phase locked loop (PLL) circuit including a programmable frequency divider, for example. The frequency division ratio of the programmable frequency divider is regulated by a controller 14 to select a broadcasting station. The detection output from the FM detector 4 is supplied to a multiplex demodulation circuit 5. As for stereo broadcasting, the detection output is divided into audio signals for right and left channels in the multiplex demodulation circuit 5. The output from the multiplex demodulation circuit 5 is sent out as a reproduced audio output through a function changeover circuit (not shown).

The detection output from the FM detector 4 is passed through a filter 6 so that a radio data signal corresponding to a subcarrier wave (which is subjected to amplitude modulation by a data signal converted into biphase codes and has a frequency of 57 kHz) is extracted. The radio data signal is demodulated by a phase locked loop circuit 7, the demodulation output from which is supplied to a digital phase locked loop (D-PLL) circuit 8 and a decoder 9. In the D-PLL circuit 8, a clock signal for data modulation is generated on the basis of the demodulation output from the PLL circuit 7. The clock signal is supplied to a gate circuit 10.

When a lock detector circuit 11 has detected the locking of the D-PLL circuit 8, it generates a signal which is supplied to the gate circuit 10 to turn it on.

In the decoder 9, the data signal which is converted into the biphase codes and is the demodulation output from the PLL circuit 7 is decoded synchronously with the clock signal generated by the D-PLL circuit 8. The output data from the decoder 9 consists of groups each made up of 104 bits consisting of four 26-bit blocks as shown in FIG. 3, and is supplied to a group and block synchronization and error detection circuit 12 in which group and block synchronization is performed on the basis of 10-bit offset words allocated to the 10-bit check words of the blocks and error detection is performed as to a 16-bit information word on the basis of the check word. Data errors detected in the circuit 12 are corrected by an error correction circuit 13 and then supplied to the controller 14.

The controller 14 comprises a microcomputer so that radio data which are the codes in blocks, sequentially received in the unit of a group and, such as the PI data, the AF data and the PS data are entered into the controller and stored in a memory 15. A received frequency data value for determining the frequency division ratio of the programmable frequency divider of the PLL circuit of the front end 2 is regulated by the controller 14 on the basis of a station choosing command from an operator section 16 so to choose a broadcasting station.

A level detection circuit 17, by which the level (the intensity of electric field) of the signal received by the RDS receiver is found on the basis of the level of an IF signal in the IF amplifier 3, and a station detection circuit 18 are provided. When the IF signal in the IF amplifier 3 is not lower than a prescribed level and the level of the S-curve-characteristics detection output from the FM detector 4 is in a prescribed range, the station detection circuit 18 judges a station to be detected by the receiver and sends out a station detection signal. The received signal level detection output from the level detection circuit 17 and the station detection output from the station detection circuit 18 are supplied to the controller 14.

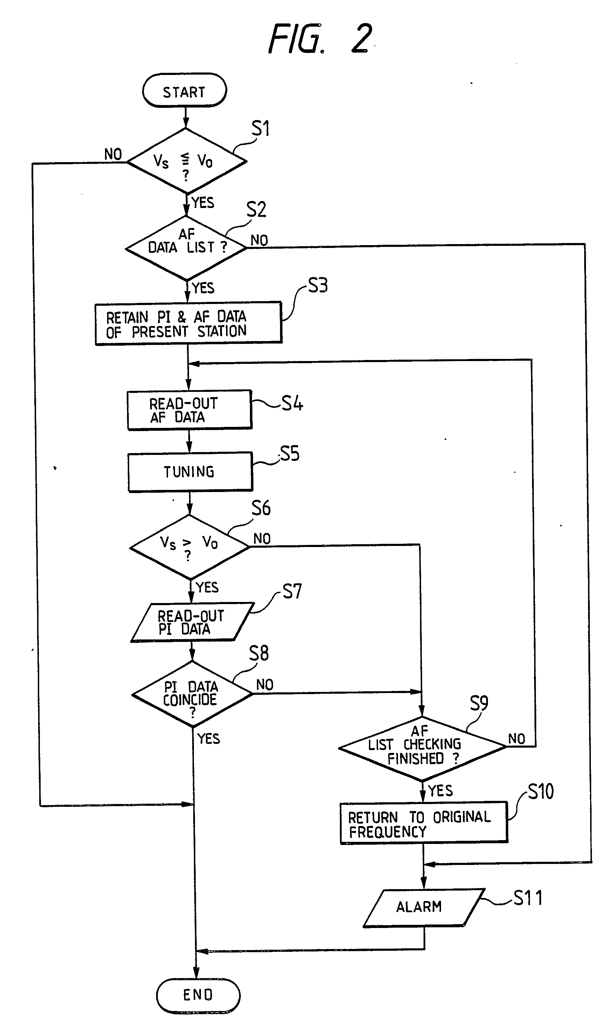

The steps of the method, which are taken by the processor of the controller 14, are now described with reference to FIG. 2. It is herein supposed that AF data obtained by demodulating a received broadcasting wave is already taken into a memory 15 to create the AF data list $f_1$, $f_2$, $f_n$ of broadcasting stations constituting the same network as the broadcasting station whose broadcast signal is presently received by the RDS receiver.

In the first step S1, the processor monitors whether or not a received signal level Vs sent out by the level detection circuit 17 is lower than a reference level Vo, to judge whether or not the state of reception of the broadcasting wave at the present received frequency of the receiver has deteriorated. When the processor has judged that the received signal level Vs is not higher than the set level Vo ($Vs \leq Vo$) the processor judges in the step S2 whether or not the AF data list is present in the memory 15. When the processor has judged in the step S2 that the AF data list is present in the memory 15, PI data obtained from the presently received broadcasting wave and the AF data are taken in and retained in an accumulator or the like in the step S3. The processor then reads out the AF data in the list from the memory 15 in accordance with the list, in the step S4, and sends out the read-out data to the PLL circuit (not shown) of the front end 2 to perform tuning in the step S5. The processor then judges in the step S6 whether or not the received signal level Vs sent out from the level detection circuit 17 is higher than the set level Vo. If the processor has judged in the step S6 that the received signal level Vs is higher than the reference level Vo ($Vs > Vo$), the PI data indicative of the broadcasting stations constituting the same network as the broadcasting station whose broadcasting wave is received by the receiver, is entered in the step S7. The processor then judges in the step S8 whether or not the entered PI data coincide with those retained in the accumulator or the like. If the processor has judged in the step S8 that the entered PI data coincide with those retained in the accumulator, the frequency of the broadcasting station whose broadcasting wave is presently received by the receiver is set as the new received frequency thereof so that the receiver is put in a normal reception mode.

If the processor has judged in the step S6 that the received signal level Vs is not higher than the set level Vo (Vs≦Vo) or if the processor has judged in the step S8 that the entered PI data do not coincide with those retained in the accumulator, the processor judges in the step S9 whether or not checking the received signal level with regard to the frequencies of all the broadcasting stations, on which AF data is already stored in the memory 15, has been completed. If the processor has judged in the step S9 that the checking has not been completed, the processor takes the step S4 again to repeatedly try to choose a broadcasting station capable of being well received by the receiver, in accordance with the AF data list. If the processor has judged in the step S9 that the checking has been completed, the processor judges that the AF data list does not have frequencies at which the broadcasting constituting the network can be well received by the receiver at present. In that case, the processor retrieves the AF data retained in the step S3, to return to the original received frequency in the step S10. Subsequently, a warning sound is made, for example, to notify the listener of the receiver that no RDS broadcasting wave can be received by the receiver at the presently received frequency and the change of the present received frequency to the frequency of another one of the broadcasting stations, which is given by the AF data on the stations, has not been completed, in the step SII.

If the processor has judged in the step S1 that the state of reception of the presently received broadcasting station is good, the processing by the processor is immediately ceased.

If the processor has judged in the step S2 that the AF data list is not present in the memory 15, the processor immediately takes the step S11 to make the warning sound.

When no RDS broadcasting wave can be received by the receiver at the present frequency thereof for one of the broadcasting stations and the change of the present received frequency to the frequency for another one of the broadcasting stations, which is given by the AF data on the stations, has not been completed, the listener of the receiver is notified of this situation so as to enable him to cope with it quickly, for example so that he can choose a broadcasting station of the same PI data, for example. The listener can thus be prevented from failing to listen to road traffic information in a road traffic annoucement interruption waiting state, for example. For that reason, the method is effective for an interruption waiting state in particular.

Although the warning sound is made for the notification in the above-described embodiment, the present invention is not confined thereto but may be otherwise embodied so that a display unit having a display function not for the notification is jointly used, for example being turned on and off for the notification.

Although the listener is able to choose the broadcasting station of the same PI data after the making of the warning sound in the above-described embodiment, the present invention is not confined thereto but may be otherwise embodied so that a seeking action is perfomed as soon as the making of the warning sound to automatically choose a broadcasting station of the same PI data.

## Claims

1. An RDS receiver for receiving an RDS broadcast signal carrying network station frequency data, characterised in that:
the RDS receiver has the function of following a program in which a controlling means (14) determines if an RDS broadcast signal is received by the receiver at the present received frequency thereof for one of plural broadcasting stations constituting a network; the controlling means determines if a change of the present received frequency to the frequency of another one of the broadcasting stations, which is stored in memory has been completed; and the controlling means (14) provides an indication to the listener of the receiver when the reception state has deteriorated and the change of frequency has been completed.

2. An RDS receiver according to claim 1, wherein the controlling means (14) performs a seeking action as soon as the making of the indication to automatically choose a broadcasting station of the same data.

3. An RDS receiver according to claim 1 or claim 2, wherein the controlling means (14) monitors whether or not the received signal level is lower than a predetermined reference level.

4. A method of controlling an RDS receiver capable of receiving an RDS broadcast signal carrying network station frequency data and which has the function of following a program comprising the steps of:
determining if the state of reception of the broadcast signal at the present received frequency of the receiver has deteriorated;
determining if a change of the present received frequency to the frequency of another one of the broadcasting stations, which is stored in memory,

has been completed; and

providing an indication to the listener of the receiver when the reception state has deteriorated and the change of frequency has been completed.

5. A method according to claim 4, further comprising the step of performing a seeking action as soon as the making of the indication to automatically choose a broadcasting station of the same data.

6. A method according to claim 4 or claim 5, wherein the RDS receiver monitors whether or not a received signal level is lower than a reference level.

# FIG. 1

# FIG. 2

START

S1 — $V_s \leqq V_o$ ? — NO / YES

S2 — AF DATA LIST ? — NO / YES

S3 — RETAIN PI & AF DATA OF PRESENT STATION

S4 — READ-OUT AF DATA

S5 — TUNING

S6 — $V_s > V_o$ ? — NO / YES

S7 — READ-OUT PI DATA

S8 — PI DATA COINCIDE ? — NO / YES

S9 — AF LIST CHECKING FINISHED ? — NO / YES

S10 — RETURN TO ORIGINAL FREQUENCY

S11 — ALARM

END

EP 0 326 746 A2

# FIG. 3

1 GROUP = 4 BLOCKS = 104 BITS

| BLOCK 1 | BLOCK 2 | BLOCK 3 | BLOCK 4 |
|---------|---------|---------|---------|

1 BLOCK = 26 BITS

| INFORMATION WORD | |
|------------------|--|

CHECK WORD & OFFSET WORD

INFORMATION WORD = 16 BITS — CHECK WORD = 10 BITS

| $m_{15}$ | $m_{14}$ | $m_{13}$ | $m_{12}$ | $m_{11}$ | $m_{10}$ | $m_9$ | $m_8$ | $m_7$ | $m_6$ | $m_5$ | $m_4$ | $m_3$ | $m_2$ | $m_1$ | $m_0$ | | $c'_9$ | $c'_8$ | $c'_7$ | $c'_6$ | $c'_5$ | $c'_4$ | $c'_3$ | $c'_2$ | $c'_1$ | $c'_0$ |

FIG. 4

EP 0 326 746 A2